# EUROPEAN PATENT APPLICATION

(11) **EP 4 283 263 A1**
(43) Date of publication of application: **29.11.2023**
(21) Application number: 21921300.6
(22) Date of filing: 17.12.2021
(51) Int. Cl.: G01J 1/02, H01L 37/00

(54) **THERMAL DETECTION ELEMENT AND IMAGE SENSOR**

(30) Priority: 25.01.2021 JP 2021009458
(71) Applicant: Sony Group Corporation, Tokyo 108-0075 (JP)
(72) Inventor: KADONO Koji, Tokyo 108-0075 (JP); IMAIZUMI Shinji, Tokyo 108-0075 (JP); OOISHI Ryota, Tokyo 108-0075 (JP); ANO Taishi, Tokyo 108-0075 (JP)
(74) Representative: D Young & Co LLP
(86) International application number: PCT/JP2021/046724
(87) International publication number: WO 2022/158199

(57) **Abstract**

Provided is a thermal type detection element that enables high sensitivity and high speed response while reducing the size of the element.

A thermoelectric conversion element 10 includes: a substrate 11; a thin film thermoelectric conversion layer 12 that is stacked on the substrate 11; a first electrode 13 on a high temperature side that is disposed on one surface of the thermoelectric conversion layer 12; a second electrode 15 on a low temperature side that is disposed on the other surface of the thermoelectric conversion layer 12; and an absorption layer 18 that is stacked in contact with the one surface of the thermoelectric conversion layer 12 and absorbs heat received from the outside. In the thermoelectric conversion element 10, the one surface is an upper surface of the thermoelectric conversion layer 12, the other surface is a lower surface of the thermoelectric conversion layer 12, the first electrode 13 is disposed at a contact surface between a lower surface of the absorption layer 18 and the upper surface of the thermoelectric conversion layer 12, and the second electrode 15 is disposed at a contact surface between the lower surface of the thermoelectric conversion layer 12 and a front surface of the substrate.

## Description

### [Technical Field]

The present technology relates to a thermal type detection element and an image sensor, and more particularly, a thermal type detection element including an absorption layer that absorbs heat received from the outside such as light and a thermoelectric conversion layer that converts a temperature change in the absorption layer into an electric signal and an image sensor.

### [Background Art]

In the related art, a thermoelectric conversion element that converts thermal energy into electrical energy using the Seebeck effect of a substance is known as an example of a thermal type detection element that has a role of a sensor that outputs a temperature change to the outside as an electric signal. For such a thermoelectric conversion element, a thermoelectric conversion element having a thin film stacked structure in which a Heusler alloy is used as a material and the spin Seebeck effect is used has been proposed in order to enable high sensitivity and high speed response.

For example, in PTL 1, a pair of Heusler alloys formed of an n-type Heusler alloy and a p-type Heusler alloy connected to each other by an electrode and a thermoelectric conversion element for extracting an electromotive force according to a temperature gradient generated in the n-type Heusler alloy and the p-type Heusler alloy have been proposed.

### [Citation List]

### [Patent Literature]

[PTL 1]
WO 2013/093967

### [Summary]

### [Technical Problem]

However, although the technology of PTL 1 has a thin film stacked structure, it does not have an element structure with a wide opening in a simple thin film structure due to local heat confinement. Therefore, further improvements are desired to enable high sensitivity and high speed response while reducing the size of the element.

Therefore, a main object of the present technology is to provide a thermal type detection element that enables high sensitivity and high speed response while reducing the size of the element.

### [Solution to Problem]

A thermal type detection element according to the present technology includes: a substrate; a thin film thermoelectric conversion layer that is stacked on the substrate; a first electrode on a high temperature side which is disposed on one surface of the thermoelectric conversion layer; a second electrode on a low temperature side which is disposed on the other surface of the thermoelectric conversion layer; and an absorption layer that is disposed on one surface side of the thermoelectric conversion layer and absorbs heat received from the outside. In the thermal type detection element according to the present technology, the one surface may be an upper surface of the thermoelectric conversion layer, the other surface may be a lower surface of the thermoelectric conversion layer, the first electrode may be disposed at a contact surface between a lower surface of the absorption layer and the upper surface of the thermoelectric conversion layer, and the second electrode may be disposed at a contact surface between the lower surface of the thermoelectric conversion layer and a front surface of the substrate.

Further, in the thermal type detection element according to the present technology, the one surface may be a lower surface of the thermoelectric conversion layer, the other surface may be an upper surface of the thermoelectric conversion layer, the first electrode may be disposed at a contact surface between the lower surface of the thermoelectric conversion layer and an upper surface of the absorption layer, and the second electrode may be disposed on the upper surface of the thermoelectric conversion layer.

Further, in the thermal type detection element according to the present technology, the one surface may be a lower surface of the thermoelectric conversion layer, the other surface may be an upper surface of the thermoelectric conversion layer, the first electrode may be sandwiched between the thermoelectric conversion layer and the absorption layer, and the second electrode may be disposed on the upper surface of the thermoelectric conversion layer.

Furthermore, the thermal type detection element according to the present technology includes a plurality of thermoelectric conversion elements and can be used in an image sensor in which the plurality of thermoelectric conversion elements are arrayed.

### [Advantageous Effects of Invention]

According to the present technology, it is possible to provide a thermal type detection element that enables high sensitivity and high speed response while reducing the size of the element. The effect is not necessarily limited. Any effect described in the present specification or other effects achievable from the present specification may be obtained in addition to the foregoing effect or instead of the foregoing effect.

### [Brief Description of Drawings]

[Fig. 1]

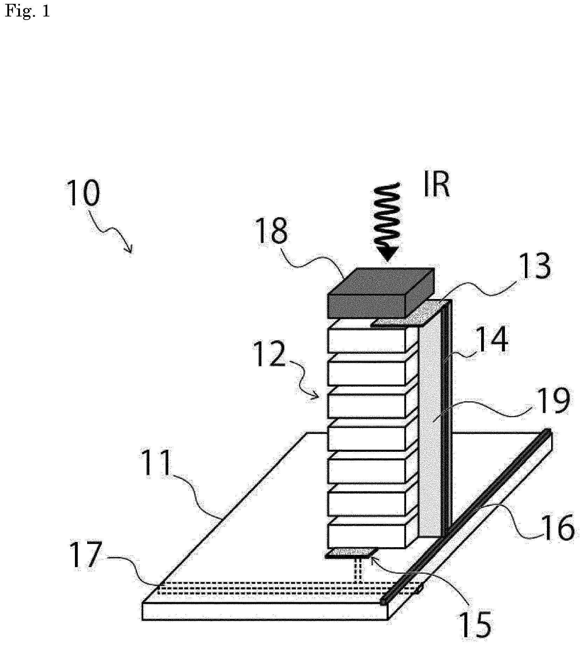

   Fig. 1 is a schematic view showing a configuration example of a thermoelectric conversion element according to a first embodiment of the present technology.
[Fig. 2]

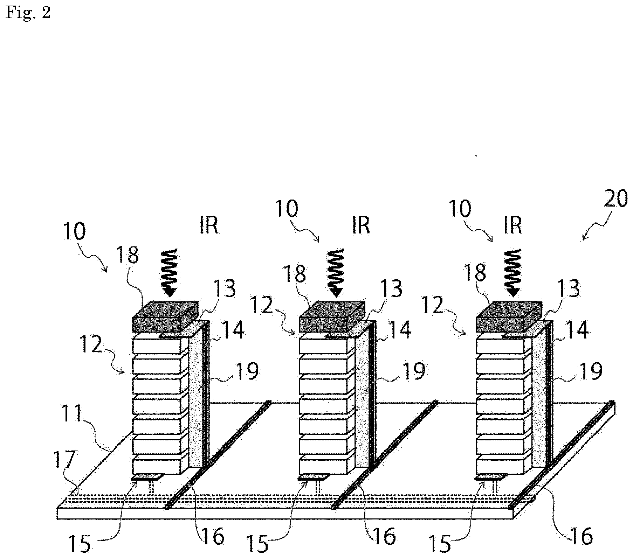

   Fig. 2 is a schematic view showing a configuration example of a thermoelectric conversion element unit according to the first embodiment of the present technology.
[Fig. 3]

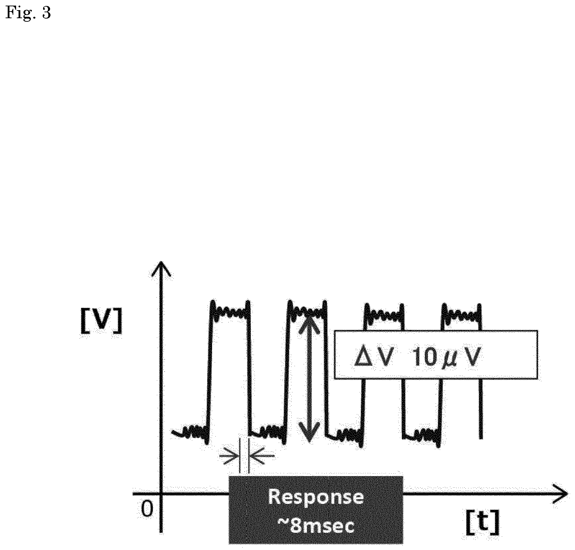

   Fig. 3 is a graph showing a measurement result of an electric signal from the thermoelectric conversion element according to the first embodiment of the present technology.
[Fig. 4]

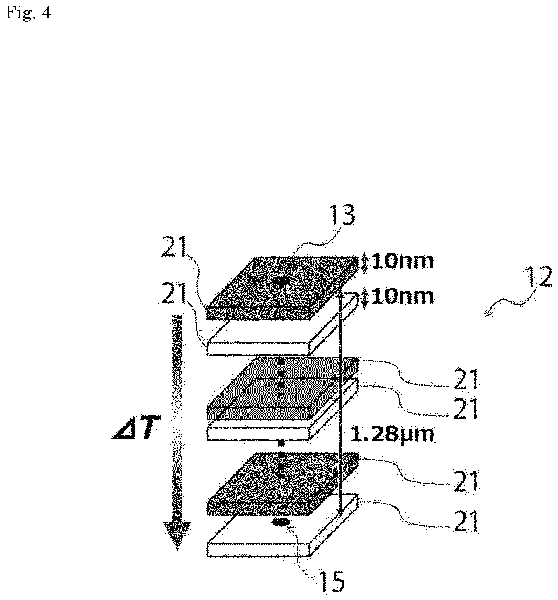

   Fig. 4 is a schematic view showing a basic element structure of a thermoelectric conversion layer according to the first embodiment of the present technology through heat transfer simulation.
[Fig. 5]

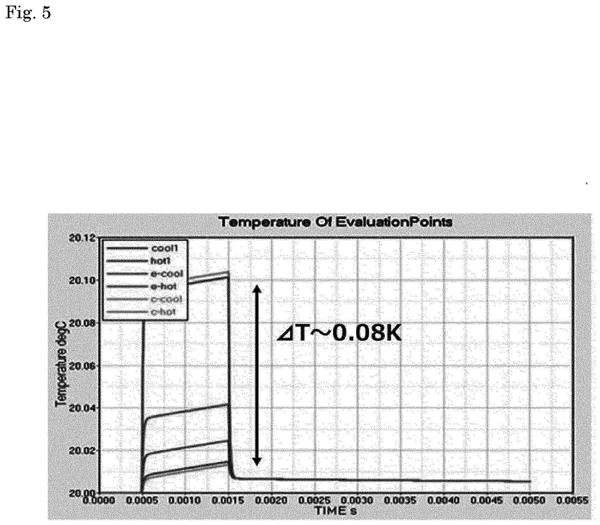

   Fig. 5 is a graph showing temperature profiles of a hot point electrode and a cold point electrode of the thermoelectric conversion element according to the first embodiment of the present technology through heat transfer simulation.
[Fig. 6]

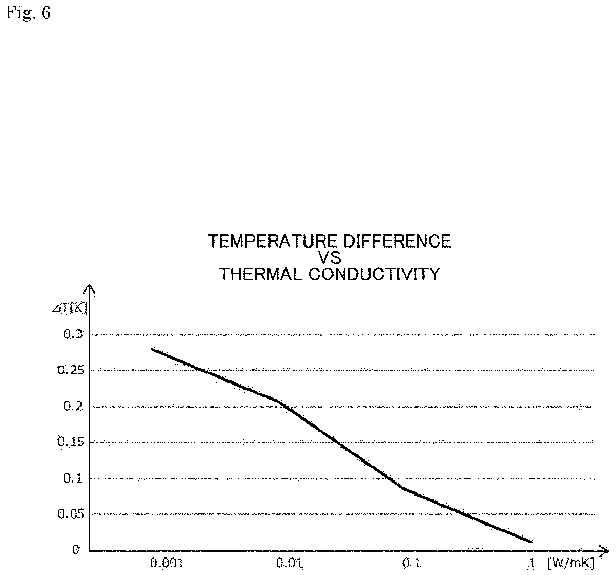

   Fig. 6 is a graph showing a heat transfer simulation result of the thermoelectric conversion element according to the first embodiment of the present technology.
[Fig. 7]

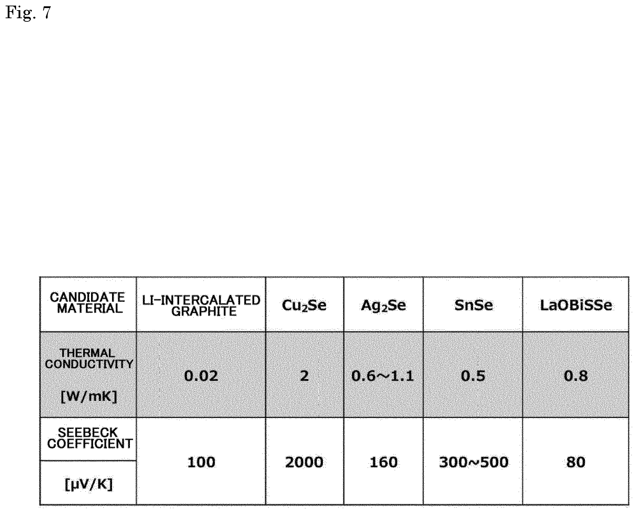

   Fig. 7 is a table showing candidate materials for the thermoelectric conversion layer according to the first embodiment of the present technology.
[Fig. 8]

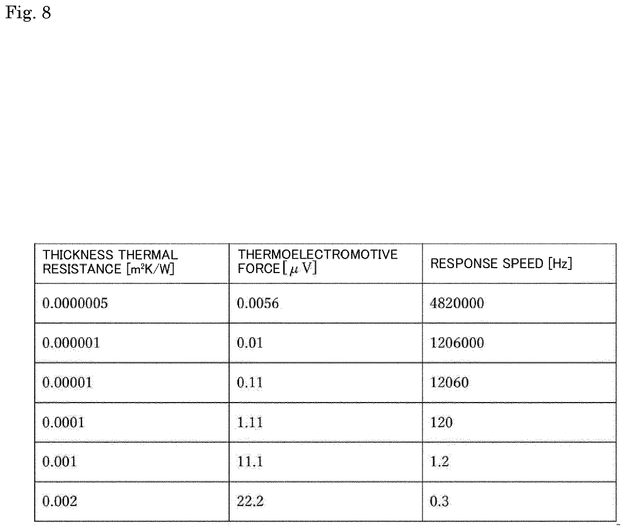

   Fig. 8 is a table showing a thickness thermal resistance of the thermoelectric conversion element according to the first embodiment of the present technology.
[Fig. 9]

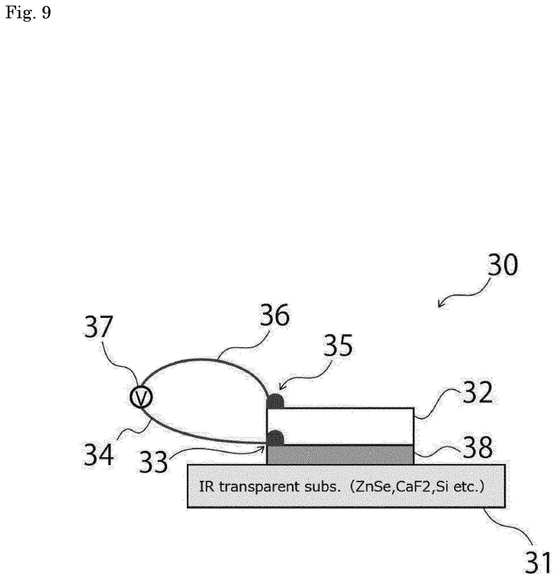

   Fig. 9 is a schematic view showing a configuration example of a thermoelectric conversion element according to a second embodiment of the present technology.
[Fig. 10]

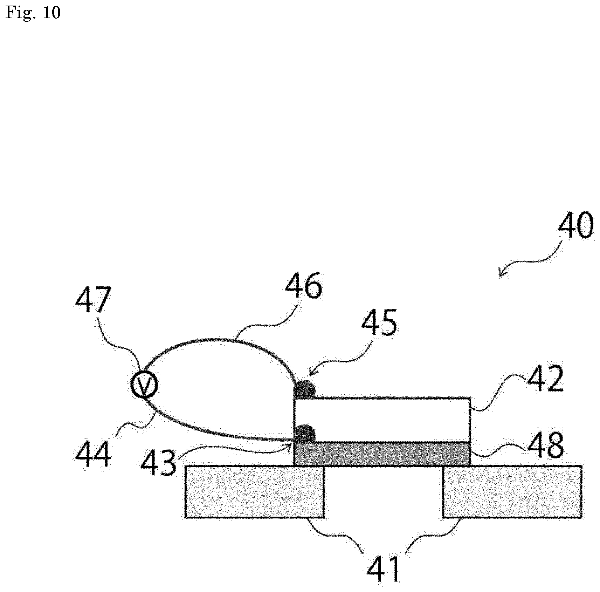

   Fig. 10 is a schematic view showing a configuration example of a thermoelectric conversion element according to a third embodiment of the present technology.
[Fig. 11]

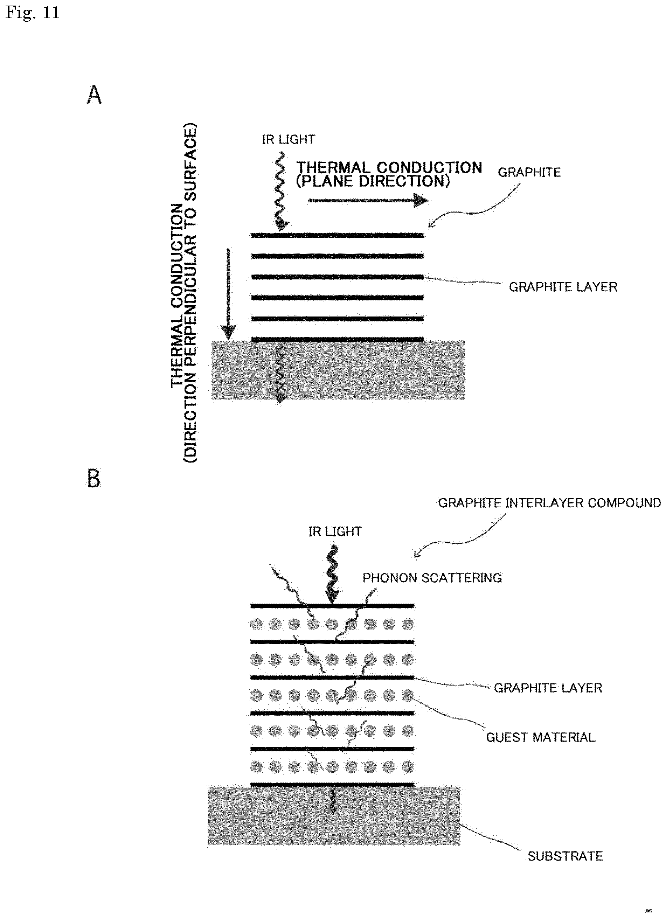

   Fig. 11A is a view for explaining a thermal conductivity of an example in which graphite is used for a thermoelectric conversion layer. Fig. 11B is a view for explaining a thermal conductivity of an example in which a graphite interlayer compound is used for a thermoelectric conversion layer.
[Fig. 12]

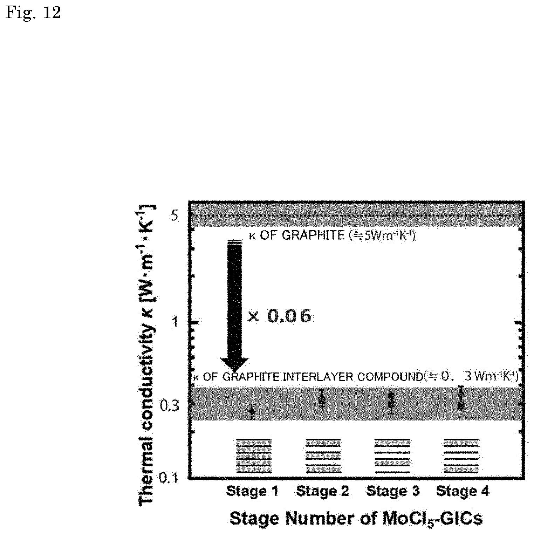

   Fig. 12 is a comparison diagram of the thermal conductivities of the graphite and the graphite interlayer compound (Stages 1 to 4).
[Fig. 13]

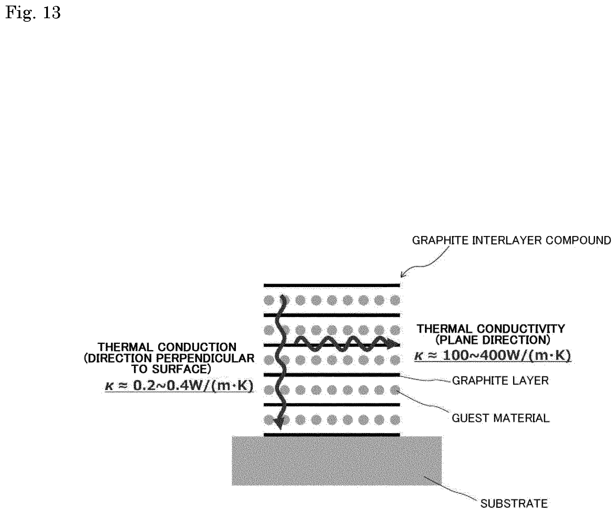

   Fig. 13 is a view for explaining thermal conduction anisotropy of a thermoelectric conversion layer of Configuration Example 1 (a graphite interlayer compound of Stage 1) of the present technology.
[Fig. 14]

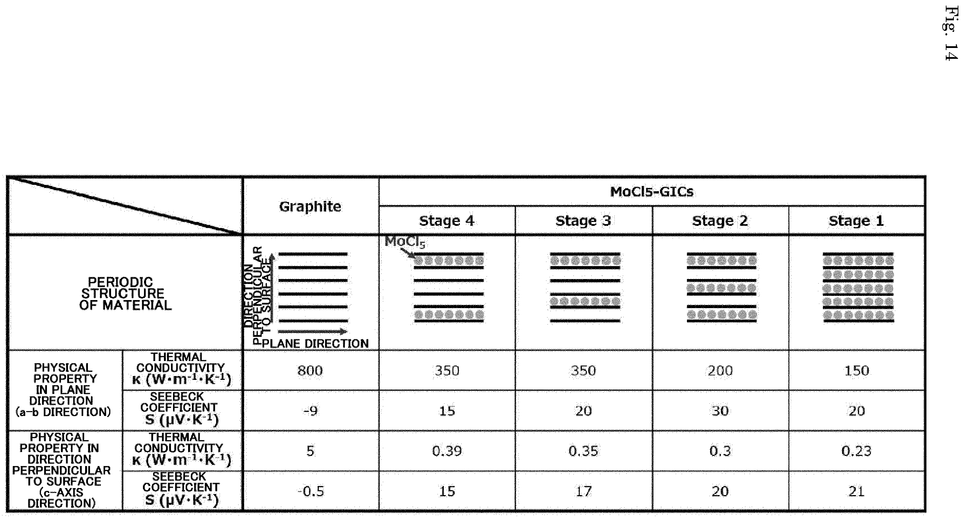

   Fig. 14 is a table showing a thermal conductivity and a Seebeck coefficient in a plane direction and a thermal conductivity and a Seebeck coefficient in a direction perpendicular to a plane of each of the graphite and the graphite interlayer compound (Stages 1 to 4).
[Fig. 15]

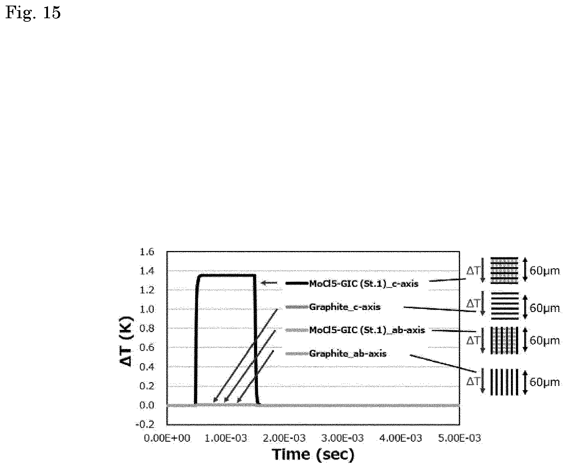

   Fig. 15 is a graph showing sensitivity and responsiveness of the graphite (two layouts) and the graphite interlayer compound (two layouts of Stage 1) as the thermoelectric conversion layer.
[Fig. 16]

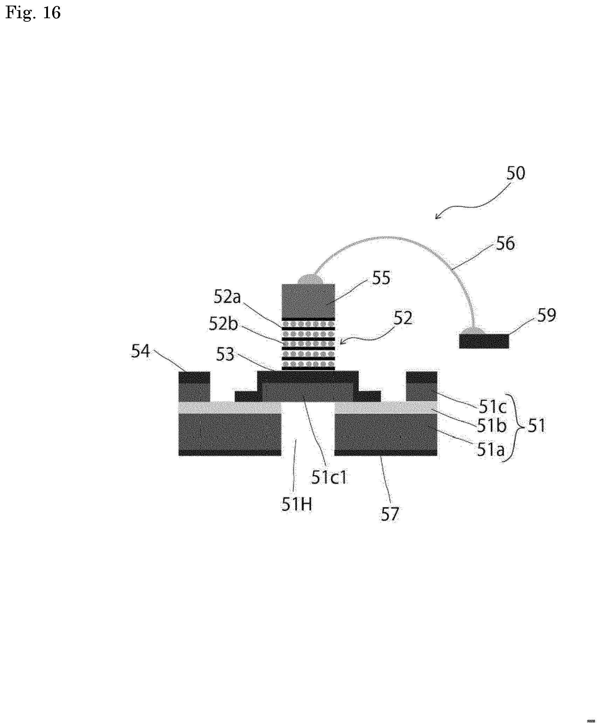

   Fig. 16 is a cross-sectional view of a thermoelectric conversion element according to Configuration Example 1 of a fourth embodiment of the present technology.
[Fig. 17]

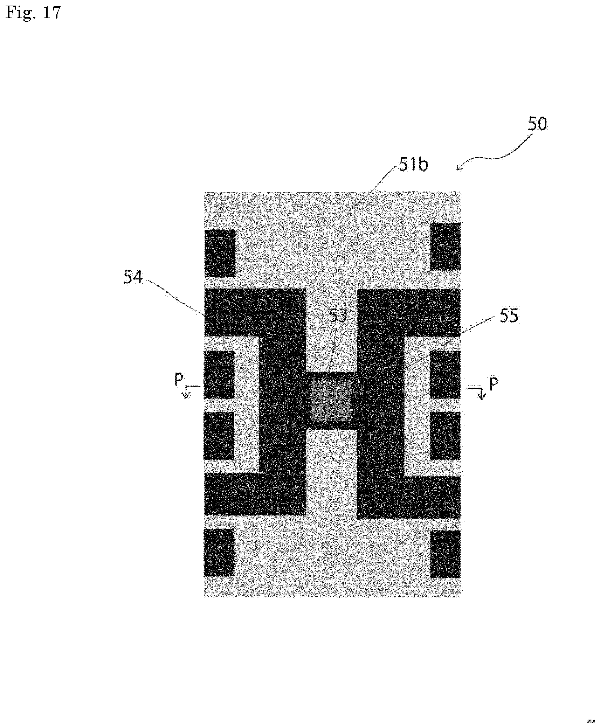

   Fig. 17 is a plan view of the thermoelectric conversion element according to Configuration Example 1 of the fourth embodiment of the present technology.
[Fig. 18]

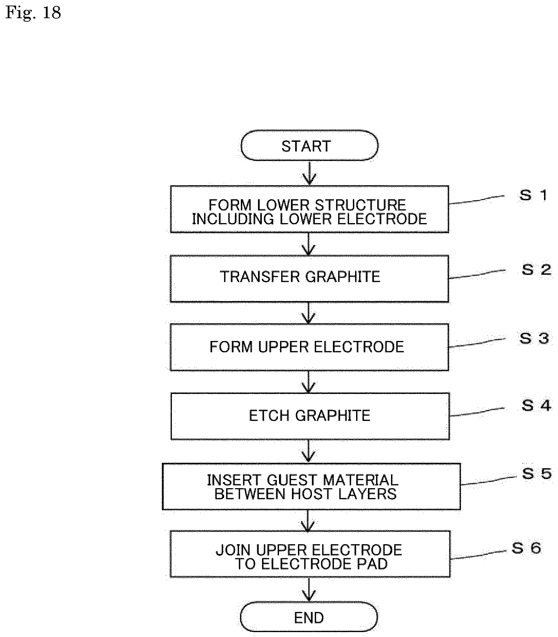

   Fig. 18 is a flowchart for explaining an example of a method of manufacturing the thermoelectric conversion element according to Configuration Example 1 of the fourth embodiment of the present technology.
[Fig. 19]

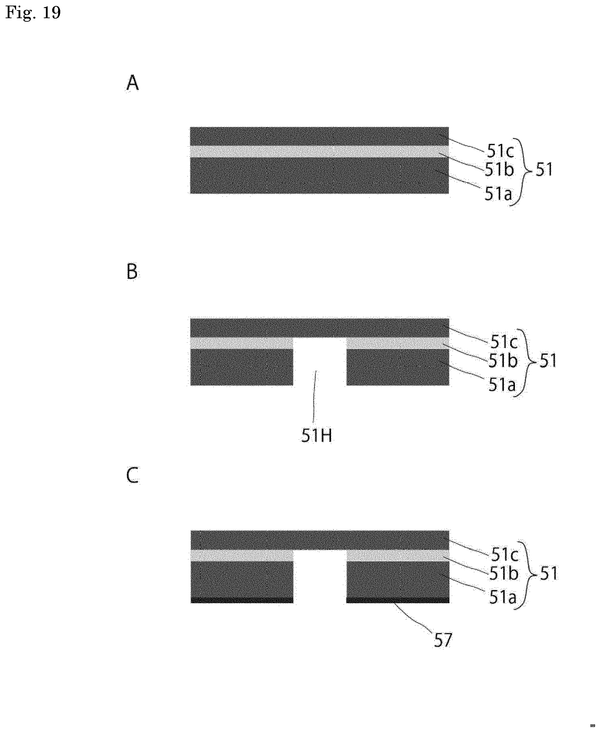

   Figs. 19A to 19C are cross-sectional views for each step of the method of manufacturing the thermoelectric conversion element according to Configuration Example 1 of the fourth embodiment of the present technology.
[Fig. 20]

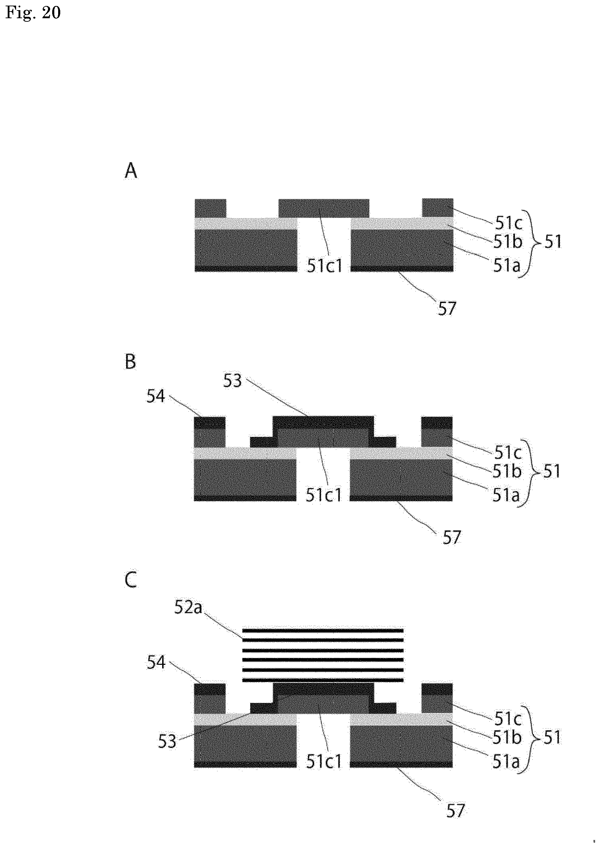

   Figs. 20A to 20C are cross-sectional views for each step of the method of manufacturing the thermoelectric conversion element according to Configuration Example 1 of the fourth embodiment of the present technology.
[Fig. 21]

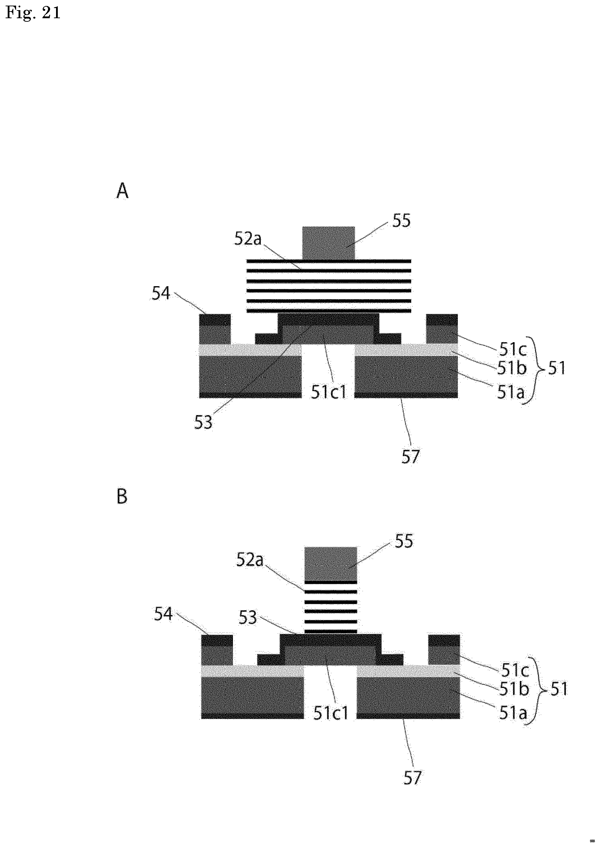

   Figs. 21A and 21B are cross-sectional views for each step of the method of manufacturing the thermoelectric conversion element according to Configuration Example 1 of the fourth embodiment of the present technology.
[Fig. 22]

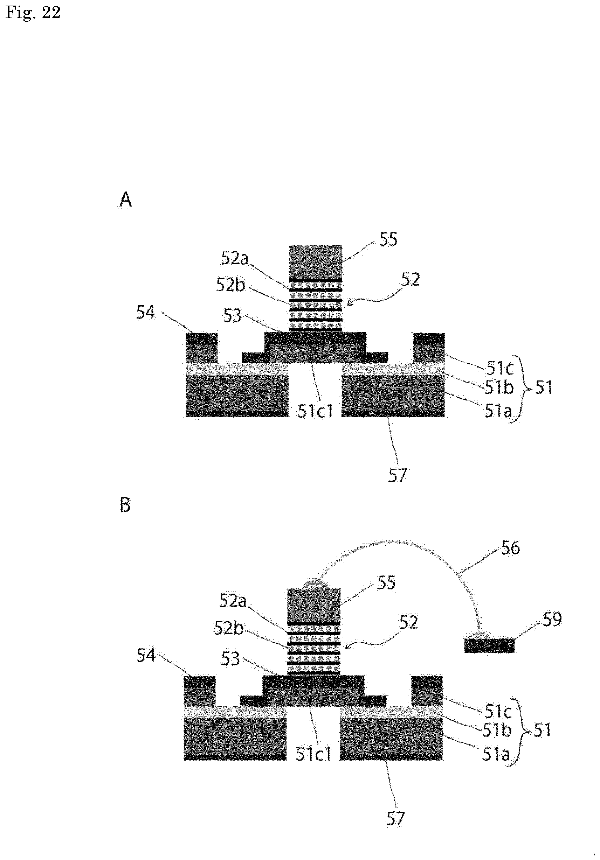

   Figs. 22A and 22B are cross-sectional views for each step of the method of manufacturing the thermoelectric conversion element according to Configuration Example 1 of the fourth embodiment of the present technology.

### [Description of Embodiments]

Hereinafter, preferable embodiments for implementing the present technology will be described with reference to the drawings. The embodiments which will be described later illustrate examples of typical embodiments of the present technology, and any of the embodiments can be combined with each other. Moreover, the scope of the present technology should not be interpreted narrower by the embodiments. The description will proceed in the following order:
1. First embodiment
   (1) Overview of thermal type detection element
   (2) Configuration example of thermoelectric conversion element 10
   (3) Operation example of thermoelectric conversion element 10
   (4) Example of method of manufacturing thermoelectric conversion element 10
   (5) Configuration example of thermoelectric conversion element unit 20
   (6) Example (simulation)
2. Second embodiment
3. Third embodiment
4. Fourth embodiment

### 1. First embodiment

### (1) Overview of thermal type detection element

First, an overview of the thermal type detection element will be described.

The thermal type detection element that has an absorption layer which absorbs light and converts the light into heat and that outputs a temperature change of the absorption layer to the outside as an electric signal is used in various fields such as temperature detection sensors and human body detection sensors. For example, a bolometer (a resistance change type) and a thermopile (a thermoelectric conversion type) are known as thermal type detection elements for mid-to-far infrared rays which operate at room temperature. These elements convert the temperature change generated due to the absorption of the infrared light into an electric signal such as a resistance change or a thermoelectromotive force and detect the temperature. However, the signal conversion layer is generally formed in a beam structure or a lateral structure extending horizontally with respect to a substrate surface in order to obtain a temperature difference by increasing the thermal resistance of the element and thus making the element into a heat insulating structure.

As a result, the increase in the area of a unit element makes it difficult to increase the number of pixels. At the same time, since the volume of the element increases and the heat capacity thereof increases, there is a limit to achieving high sensitivity and high speed response while reducing the size of the element. In addition, since an umbrella structure is required to secure a light absorption area and the like, the structure becomes a complicated three-dimensional structure, and thus the cost of a pixel miniaturization process is increasing. Furthermore, the thermoelectric conversion element is applied not only to a light detection element but also to a power generation element for energy harvesting. However, the thermoelectric conversion layer exists as a self-supporting film with a large size in a direction in which a stacked surface spreads. With this structure, it is difficult to achieve high sensitivity and high speed response while reducing the size of the element.

In addition, the related art has problems that resonance is limited to a specific wavelength, the presence of an isolated metal increases heat capacity, heat is diffused by reflection and radiation of infrared rays, and efficiency and sensitivity are lowered.

Therefore, in the present technology, the material of the thermoelectric conversion layer is devised to reduce a thermal conductivity in order to form a thin film structure while vertically stacking the thermoelectric conversion layer. As a result, according to the present technology, it is possible to provide a thermal type detection element that enables high sensitivity and high speed response while reducing the size of the element.

### (2) Configuration example of thermoelectric conversion element 10

Next, a configuration example of a thermoelectric conversion element 10, which is an example of a thermal type detection element according to a first embodiment of the present technology, will be described with reference to Fig. 1. Fig. 1 is a schematic view showing the configuration example of the thermoelectric conversion element 10.

As shown in Fig. 1, the thermoelectric conversion element 10 includes, for example, a substrate 11, a thin film thermoelectric conversion layer 12 that is stacked on the substrate 11, a hot point electrode 13 that is a first electrode on a high temperature side which is disposed on one surface of the thermoelectric conversion layer 12, a cold point electrode 15 that is a second electrode on a low temperature side which is disposed on the other surface of the thermoelectric conversion layer 12, and an absorption layer 18 that is stacked in contact with the one surface of the thermoelectric conversion layer 12 and absorbs heat received from the outside. In the thermoelectric conversion element 10, the one surface of the thermoelectric conversion layer 12 is an upper surface of the thermoelectric conversion layer 12, and the other surface thereof is a lower surface of the thermoelectric conversion layer 12.

The thermoelectric conversion layer 12 is formed on a front surface of the substrate 11 by stacking a plurality of thin films having thermoelectric conversion characteristics with a film thickness suitable for a process. On a side surface of the thermoelectric conversion layer 12, a hot point electrode wiring 14 is arranged from the upper surface to the lower surface with an insulating film 19 interposed therebetween.

The thermoelectric conversion element 10 is particularly characterized by the material of the thermoelectric conversion layer 12 because it generates a temperature difference between the upper surface of the thermoelectric conversion layer 12 and the front surface of the substrate 11 which causes a thermoelectromotive force of a detectable magnitude to be generated. From the viewpoint of wiring process suitability of the hot point electrode 13 that is the first electrode, for example, the film thickness of the thermoelectric conversion layer 12 is preferably 100 pm or less. In addition, the thermal conductivity of the thermoelectric conversion layer 12 is preferably 1 W/mK or less. Further, the Seebeck coefficient of the thermoelectric conversion layer 12 is preferably 100 pV/K or more.

Furthermore, the thermoelectric conversion layer 12 can be formed of a layered substance in which thin films are stacked. As the layered substance, a substance selected from graphite, a metal compound containing graphite as a host material, a compound containing an organic molecule or the like inserted as a guest material, a transition metal chalcogenide, and a combination thereof can be used.

The thermoelectric conversion layer 12 preferably has an inorganic superlattice structure or an organic superlattice structure. In addition, the thermoelectric conversion layer 12 can be formed of a compound consisting of elements having a large mass difference or a cage-structured molecule.

The hot point electrode 13 is disposed on the upper surface of the thermoelectric conversion layer 12 which is the contact surface with the lower surface of the absorption layer 18. In this way, the electrode formed at the interface between the absorption layer 18 of the light and the thermoelectric conversion layer 12 serves as a hot point electrode.

The cold point electrode 15 is disposed on the lower surface of the thermoelectric conversion layer 12 which is the contact surface with the front surface of the substrate 11. In this way, since the substrate 11 functions as a cold bath, the electrode formed at the interface between the substrate 11 and the thermoelectric conversion layer 12 becomes a cold point electrode. The thermoelectric conversion element 10 can be equipped with an electrometer for reading a potential between the two electrodes of the hot point electrode 13 and the cold point electrode 15.

An address line 16 serving as the hot point electrode wiring connected to the hot point electrode 13 via the hot point electrode wiring 14 is arranged at the side end portion of the front surface of the substrate 11. Further, a cold point electrode wiring 17 serving as an address line connected to the cold point electrode 15 through the inside of the substrate 11 in a direction crossing a direction in which the address line 16 is arranged is arranged on the back surface of the substrate 11. In the present embodiment, a direction in which the cold point electrode wiring 17 is arranged is orthogonal to a direction in which the address line 16 is arranged.

The absorption layer 18 is stacked on the upper surface of the thermoelectric conversion layer 12 and absorbs heat due to incident light. The absorption layer 18 transfers the absorbed heat to the thermoelectric conversion layer 12 via the hot point electrode 13. The thermoelectric conversion element 10 is, for example, a light detection element that absorbs and detects infrared light IR.

### (3) Operation example of thermoelectric conversion element 10

Next, an operation example of the thermoelectric conversion element 10 will be described. In the present embodiment, a case in which the infrared light IR is incident on the absorption layer 18 of the thermoelectric conversion element 10 is considered.

When the absorption layer 18 is irradiated with the infrared light IR and the absorption layer 18 absorbs heat due to the infrared light IR, heat associated with the absorption of the infrared light IR is generated between the hot point electrode 13 and the cold point electrode 15, and thus a temperature difference occurs. For this reason, a thermoelectromotive force is generated in the thermoelectric conversion layer 12 due to diffusion of thermal carriers.

Here, in the thermoelectric conversion element of the related art, in order to obtain a large temperature difference between the hot point electrode and the cold point electrode, a lateral structure in which the hot point electrode and the cold point electrode are provided with a certain distance in a direction in which the surface of the substrate spreads is formed. However, with the lateral structure, it is difficult to achieve miniaturization while maintaining high sensitivity and high speed response.

Therefore, the thermoelectric conversion element 10 according to the present embodiment is formed in a vertical structure in which the hot point electrode and the cold point electrode are provided with a certain distance from the front surface of the substrate 11 in a stacking direction of the thermoelectric conversion layer 12 and detects the thermoelectromotive force between the thin films, and thus it is possible to enable miniaturization while maintaining high sensitivity and high speed response.

In order to exhibit the above effects, it is necessary to increase the thermal resistance of the heat generating region of the element. Diffusion paths of heat generated due to the light absorption include heat diffusion through the thermoelectric conversion layer, the electrodes, and surrounding air. Among them, by using a material with a low thermal conductivity in a direction perpendicular to the thin film for the thermoelectric conversion layer 12 which is a main heat diffusion path, it is possible to form the thermoelectric conversion element 10 that is also suitable for a wiring process such as electrode formation on the front surface and has high light utilization efficiency and few useless diffusion paths and an infrared ray detection element using the same.

### (4) Example of method of manufacturing thermoelectric conversion element 10

Next, an example of a method of manufacturing the thermoelectric conversion element 10 according to the present embodiment will be described.

As an example of the method of manufacturing the thermoelectric conversion element 10, in step 1, the thermoelectric conversion layer 12 of the thin film is stacked on the front surface of the substrate 11. In step 2, the hot point electrode 13 which is the first electrode on the high temperature side is disposed on the upper surface of the thermoelectric conversion layer 12. In step 3, on the side surface of the thermoelectric conversion layer 12, the hot point electrode wiring 14 is arranged from the hot point electrode 13 on the upper surface to the lower surface of the thermoelectric conversion layer 12 with the insulating film 19 interposed therebetween. In step 4, the cold point electrode 15 which is the second electrode on the low temperature side is disposed on the lower surface of the thermoelectric conversion layer 12. In step 5, the absorption layer 18 that absorbs heat received from the outside is stacked in contact with the upper surface of the thermoelectric conversion layer 12. In step 6, the address line 16 serving as the hot point electrode wiring connected to the hot point electrode 13 via the hot point electrode wiring 14 is arranged at the side end portion of the front surface of the substrate 11. In step 7, the cold point electrode wiring 17 serving as an address line connected to the cold point electrode 15 through the inside of the substrate 11 in a direction orthogonal to a direction in which the address line 16 is arranged is arranged on the back surface of the substrate 11.

### (5) Configuration example of thermoelectric conversion element unit 20

Next, a configuration example of a thermoelectric conversion element unit 20 according to the present embodiment will be described with reference to Fig. 2. Fig. 2 is a schematic view showing a configuration example of the thermoelectric conversion element unit 20.

As shown in Fig. 2, the thermoelectric conversion element unit 20 includes a plurality of thermoelectric conversion elements 10, and the plurality of thermoelectric conversion elements 10 are arrayed in a direction in which the surface of the substrate 11 spreads.

The thermoelectric conversion element unit 20 can be used as an image sensor, for example, by the thermoelectric conversion elements 10 being arrayed in the direction in which the surface of the substrate 11 spreads.

### (6) Example (simulation)

Next, an example (simulation) of electrical signal measurement using the thermoelectric conversion element 10 according to the present embodiment will be described with reference to Figs. 3 to 8.

In the present example, a black body sensitivity test was performed in accordance with the Ministry of Defense standard "Infrared ray imaging device detector system test method." The following are measurement setup procedures that refer to the above test method.

First, in front of an opening of the black body furnace, a mask with a circular aperture having a smaller diameter than the opening is placed. At this time, a standard diameter of an opening of the circular aperture mask is 5 mm.

Second, a chopper is placed between the opening of the black body furnace and the circular aperture mask. The circular aperture mask is large enough to hide the chopper, and the circular aperture mask and the chopper are kept away from the black body furnace not to raise temperature thereof. At this time, the circular aperture mask and the chopper are black-bodied not to cause an error in RBB measurement, and an emissivity is kept at 0.95 or higher.

Third, the detector under test is placed in front of the circular aperture mask such that infrared light from the opening of the black body furnace is incident perpendicularly on a photosensitive portion of the detector under test. A distance between the circular aperture mask and the detector under test is at least 25 times the diameter of the circular opening. At this time, a measurement system should be far enough away from a wall such that the infrared light is not reflected, and unnecessary objects should not be placed around the measurement system. A chopping frequency is a prescribed value.

Fig. 3 is a graph showing a measurement result of an electric signal from the thermoelectric conversion element 10 (time dependence of an output voltage). The horizontal axis of Fig. 3 represents time (t), and the vertical axis of Fig. 3 plots the thermoelectromotive force generated between the hot point electrode 13 and the cold point electrode 15 as an output voltage (V).

The graph shown in Fig. 3 shows a result that a potential between the hot point electrode 13 and the cold point electrode 15 is measured by an electrometer at intervals of 1 msec (1 millisecond) or less when infrared light is applied as a rectangular wave at a constant cycle. A constant noise voltage is obtained in the absence of infrared irradiation, but the voltage rises with light irradiation, and an output voltage that is superior to the noise voltage is measured. When the infrared irradiation is turned off from there, the output voltage drops quickly, and a noise voltage is observed. At this time, a black body light source is used for the infrared irradiation, the temperature thereof is 310 K, and the illuminance thereof is about 51 W/m².

In contrast, the voltage output from the element was approximately 10 µV. In addition, even in a case where the light is turned on and off at a cycle of 1 Hz to 100 Hz, the output voltage signal changes to well follow thereto, and when the time required for the voltage change to stabilize at the time of turning on and off is taken as a reaction speed, a value of about 8 msec was obtained.

Next, a material and the like and a result of electrothermal simulation of the thermoelectric conversion element 10 used in the present example will be described with reference to Figs. 4 to 6. First, the material and the like of the thermoelectric conversion element 10 used in the present example will be described.

In the material synthesis of the thermoelectric conversion layer 12, Li ions were inserted into a highly oriented pyrolytic graphite (Alliance biosystems, Inc. Tomoe Engineering Co., Ltd., and the like) via an electrolyte by a charge transfer method. The insertion time was set to 40 seconds such that the composition ratio of the inserted material was LiC₂₄.

In the formation of the cold point electrode 15, a pad with a square aperture surface of 12 pm × 12 pm and a wiring addressed with a line width of 2 pm with respect to the pad were formed on a Si wafer with a thermally oxidized film having a film thickness of 270 nm with Al in a film thickness of 20 nm.

In the transfer formation of the thermoelectric conversion layer 12, the thermoelectric conversion layer 12 was formed to be joined to the electrode by transferring the above LiC₂₄ to the cold point electrode 15 portion. At this time, the transfer formation was performed until the LiC₂₄ was transferred to a predetermined position on a wafer with an applied constant pressure from pickup using a manipulator with a diameter of 50 pm under a nitrogen gas atmosphere. The film thickness of the transferred LiC₂₄ is 24 pm. A square aperture surface of 12 pm × 12 pm was formed using a photolithography process with this LiC₂₄.

In the formation of the insulating film 19, a SiN film of 100 nm (depth) × 2 pm (width) × 2.38 pm (height) was formed on one side of the thermoelectric conversion layer 12.

In the formation of the hot point electrode 13, a wiring electrode with a film thickness of 20 nm and a line width of 2 pm which is joined to the front surface of the thermoelectric conversion layer 12 with the insulating film 19 interposed therebetween was formed.

In the formation of the absorption layer 18, a niello film with a film thickness of 100 nm was formed on the front surface of the thermoelectric conversion layer 12.

In the formation of a signal amplification circuit, a side of the cold point electrode 15 was grounded, and an operational amplifier with a positive load applied to a side of the hot point electrode 13 was connected to a connecting amplification circuit. As the amplification circuit, LMP7732 (Texas instruments, Inc.) was used.

The electrical signal was measured by receiving light at 40 °C from a 2 cm square light emitting surface of a black body light source at a distance of 10 cm in a measurement environment of 25 °C, and the measurement data shown in Fig. 5 was obtained.

As the material of the thermoelectric conversion layer 12, a material having a thermal conductivity in a direction perpendicular to a surface of 1 W/mK or less and a Seebeck coefficient exceeding 10 pV/K when thinned can be used.

As an example, each of TiS and a material in which an organic molecule is inserted into TiS becomes an effective thermoelectric conversion layer 12. In addition, a layered compound such as AgCrSe₂ or WSe₂, an insert thereof, BiTe, or the like can be used. A superlattice structure in which an organic molecule or the like is formed periodically or aperiodically on TiO₂ or ZnO also becomes an effective thermoelectric conversion layer 12. A SiGe superlattice or a bulk heterostructure of Si and Ge also becomes an effective thermoelectric conversion layer 12.

Fig. 4 is a schematic view showing a basic element structure of the thermoelectric conversion layer 12 according to the thermoelectric conversion element 10 through heat transfer simulation. In the present example, the thickness of each thin film 21 of the thermoelectric conversion layer 12 is set to 10 nm, and the thickness of the entire thermoelectric conversion layer 12 in which these thin films 21 are stacked is set to 1.28 pm. The thermal conductivity of the thermoelectric conversion layer 12 at this time is 0.1 W/mK.

Fig. 5 is a graph showing temperature profiles of the hot point electrode 13 and the cold point electrode 15 of the thermoelectric conversion element 10 estimated through heat transfer simulation. The horizontal axis of Fig. 5 indicates time (s), and the vertical axis of Fig. 5 indicates temperature (°C).

Fig. 5 shows temperature changes at positions of a total of six points of three points near the hot point electrode 13 and three points near the cold point electrode 15 in a case where heat equivalent to 1.0 × 10⁻⁶ W is generated in the absorption layer 18 between 5.0 × 10⁻⁴ sec and 15.0 × 10⁻⁴ sec. From Fig. 5, it can be seen that a temperature difference of approximately 0.08 K occurs between the hot point electrode 13 and the cold point electrode 15 for the size of the thermoelectric conversion element 10 in the above case. It was also found that this temperature difference occurs at a response speed of about 1.0 × 10⁻⁴ sec.

Fig. 6 is a graph showing a heat transfer simulation result of the thermoelectric conversion element 10. The horizontal axis of Fig. 6 indicates the thermal conductivity (W/mK), and the vertical axis of Fig. 6 indicates the temperature difference ΔT (K).

The graph of Fig. 6 shows a relationship between the temperature difference and the thermal conductivity of the thermoelectric conversion layer 12 based on the heat transfer simulation result. It can be seen from Fig. 6 that the temperature difference increases as the thermal conductivity decreases.

A minimum of 0.01 µV is required as the output voltage of the element in a case where a signal amplification circuit used in a general thermopile or other potential detection circuits are used. In the thermoelectric conversion element 10, this output voltage is secured as the basis for the above-described numerical limit range.

In addition, as shown in the above simulation result, considering the pixel area, the electrode pattern, the incident light intensity, and the like of the element generally assumed, in a thin film having a film thickness of about 1 pm with a thermal conductivity of 0.01 W/mK, a temperature difference of about 0.2 K can be generated in a direction perpendicular to a surface, and a thermoelectromotive force of 10 µV can be obtained if the Seebeck coefficient is 100 pV/K. If the thermal conductivity is 0.1 W/mK, the temperature difference is about 0.08 K, and in order to obtain a thermoelectromotive force of 10 pV, the Seebeck coefficient of the material has to be 125 pV/K.

Fig. 7 shows candidate materials for the thermal conductivity, which is an index for generating a sufficient temperature difference between the electrodes, and the Seebeck coefficient for determining the thermoelectromotive force generated with the temperature difference.

As shown in Fig. 7, as a thermoelectric material having a low thermal conductivity for the thermoelectric conversion layer 12 suitable for the present technology, that is, as a material with a thermal conductivity of 1 W/mK or less or a Seebeck coefficient of the thermoelectric conversion layer 12 of 100 µV/K or more, for example, Li-intercalated graphite, Cu₂Se, Ag₂Se, SnSe, or LaOBiSSe can be used.

In particular, as examples of the thermoelectric conversion materials, metal chalcogenide materials such as Cu₂Se and Ag₂Se are promising materials.

As an example, a case where the thermoelectric conversion material is Cu₂Se will be described. In this case, high-purity powders of Cu (99.95%) and Se (99.99%) were uniformly mixed in an agate mortar to obtain Cu₂Se mixed powders. The mixed powders were prepared by uniaxial cold pressing at 60 MPa to obtain pellets with a diameter of 10 mm. Subsequently, a self-propagating high-temperature synthesis method was performed in a vacuum chamber at a base pressure of about 5 × 10⁻³ Pa to obtain a polycrystalline ingot containing only an α-phase of Cu₂Se. This ingot was pulverized again into powders using an agate mortar and a pestle to obtain uniform powders of Cu₂Se. The obtained powders were sintered at 700 °C for 3 min under a uniaxial pressure of 70 MPa by spark plasma sintering using a carbon mold and a punch to obtain a dense ingot without large defects.

Next, a case where the thermoelectric conversion material is Ag₂Se will be described. In this case, silver (99.999%; Kojundo Chemical Laboratory), selenium (99.9%; Kojundo Chemical Laboratory), and sulfur (99.9999%; Kojundo Chemical Laboratory) were used as purification materials without additional purification. Ag₂SeCh_{Y} (Ch represents Se or S; Y is 0, 0.005, 0.01, 0.015, 0.02, 0.04, 0.06, or 0.07) was mixed at each composition, and a plurality of ingots with each weight of 8 g were enclosed in carbon-coated fused silica tubes with outer and inner diameters of 12 mm and 10 mm, respectively. For example, Ag₂SeS0.01 was prepared by mixing 5.7852 g of Ag, 2.1173 g of Se, and 0.0086 g of S. Each quartz tube containing the prepared mixture was evacuated under a pressure of about 10⁻³ Pa and then flame-sealed. The whole mixture was then heated to 1273 K with a heating rate of 65 K/h, held at that temperature for 12 hours, and then cooled to 723 K with a cooling rate of 11 K/h. The cooled ingot was then annealed at 723 K for 24 hours and then cooled at room temperature for 15 hours. As a result, a dense ingot of Ag₂Se was obtained.

Next, the thickness thermal resistance of the thermoelectric conversion layer according to the present example will be described with reference to Fig. 8. Fig. 8 is a table showing the thickness thermal resistance (m²K/W) of the thermoelectric conversion layer 12 of the thermoelectric conversion element 10 according to the present example. Here, the thickness thermal resistance is obtained by dividing the film thickness (m) by the thermal conductivity (W/mK).

The numerical values shown in Fig. 8 are results of numerical calculation of the temperature difference (K) and the response speed (Hz) expected in the thermoelectric conversion element 10 of the present example when there is infrared ray irradiation of about human body temperature using the thermal conductivity of the thermoelectric conversion layer and the film thickness of the element as variables. This numerical calculation can be obtained by using a general device simulator or by analytically solving a heat conduction equation. As a prerequisite for the calculation in Fig. 8, the amount of infrared rays applied to the thermoelectric conversion element 10 is 300 W/m², and the optical system has an F value (a value obtained by dividing a focal length of the lens by an effective aperture) of 2 that is equivalent to that of a general thermoelectric conversion element, and the amount of heat generated is equivalent to 1.0×10⁻⁶W.

Here, the output voltage, which is the basic performance of the thermoelectric conversion element 10 that is an infrared ray detection element, is required to be higher than the noise of a signal circuit, and thus the output voltage needs to be 0.01 µV or more. Furthermore, it is desirable that the output voltage be 0.1 µV or more, which is an order of magnitude higher than the noise. In addition, in order to detect a moving living body without blurring, a response speed of 1.2 Hz or more is required for the response speed of the element that can follow the movement of the living body. Furthermore, a response speed of 120 Hz or higher is desirable in order to grasp situations in which the detector side moves in addition to the subject and to grasp a moving object in close proximity.

However, from the viewpoint of film formation time and film strength, increasing the film thickness beyond 100 pm increases the cost. Furthermore, since it is difficult to wire an upper electrode on this film thickness step surface, the film thickness is preferably thin. For this reason, the film thickness is preferably 100 pm or less, and more preferably 10 pm or less in view of the process.

However, from the viewpoint of film formation time and film strength, increasing the film thickness beyond 100 pm increases the cost. Furthermore, since it is difficult to wire an upper electrode on this film thickness step surface, the film thickness is preferably thin. For this reason, the film thickness is preferably 100 pm or less, and more preferably 10 pm or less in view of the process.

In Fig. 8, the thickness thermal resistance is used as an index, and the thermoelectromotive force (pV) calculated with the Seebeck coefficient, which is the physical property of the material for determining the thermoelectromotive force, as 100 pV/K and the response speed (Hz) are shown. Here, the thermoelectromotive force has to be 0.01 pV, which is the noise lower limit of the signal processing circuit, or more, and the response speed of the thermoelectric conversion element 10 has to be practically 1.2 Hz or more. This is because the specifications of a ROIC circuit for voltage detection and the operating speed of 1.2 Hz or less cause blurring and the thermoelectromotive force cannot be detected. However, it is desirable for the detection circuit to have an output of 0.1 µV or more, which is an order of magnitude higher than the noise, and a response speed of 120 Hz or more is required to capture a general moving subject.

From the above, the thickness thermal resistance per unit cross-sectional area of the thermoelectric conversion layer 12 in the thermoelectric conversion element 10 is preferably 1.0 × 10⁻⁶ m²K/W or more and 1.0 × 10⁻³ m²K/W or less, and more preferably 1.0 × 10⁻⁵ m²K/W or more and 1.0 × 10⁻⁴ m²K/W or less. In a case where the thickness thermal resistance exceeds 1.0 × 10⁻³ m²K/W, the response speed does not exceed 1.2 Hz, and in a case where the thickness thermal resistance is less than 1.0 × 10⁻⁶ m²K/W, the value of the thermoelectromotive force (the output voltage) falls short of the voltage required for signal processing.

As described above, the characteristics of a comparative example out of the preferred range shown in Fig. 8 are values that do not satisfy the necessary requirements as element characteristics. In addition, increasing the film thickness to 100 pm or more causes a limit on the process of fabricating the element. That is, it is not realistic because there is no technique for etching in the film thickness direction.

Furthermore, in addition to the above comparative example, it is necessary to satisfy the Seebeck coefficient of 100 pV/K or more at the same time in order to obtain the effect of the present technology. In general, the measurable output voltage should be above the noise of the environment. Practically, it is very difficult to read with an IC circuit unless the voltage is 0.01 µV or more. Therefore, in addition to the temperature difference described above, the physical property of the material for generating a Seebeck coefficient of 100 µV/K is a condition for obtaining the effects of the present technology.

In the present embodiment, a simple vertical heat detection element in which the absorption layer on which infrared light is incident is a hot point, the contact surface with the substrate is a cold point, and the thermoelectric conversion layer made of a thin film material with low thermal conductivity is provided between them is proposed. As a result, the opening can be widened, and the heat generated because the hot point electrode is not in contact with the substrate is prevented from diffusing directly to the substrate. Therefore, it is possible to make a simple element structure that has high light utilization efficiency and does not cause excessive heat diffusion. As a result, the element heat capacity is small, and high sensitivity and high speed response, multi-pixels, and low cost can be achieved.

The thermoelectric conversion layer 12 and the absorption layer 18 may be made of the same material. In addition, the air between the elements may be depressurized to curb heat transfer. Further, the area of one pixel may be about 100 µM², which is about the diffraction limit, but may be smaller than that. Furthermore, in order to realize this element structure, the film thickness between the electrodes, which was thick in the related art, is reduced to a processable level of, for example, 10 pm or less.

### 2. Second embodiment

Next, a configuration example of a thermoelectric conversion element 30 according to a second embodiment of the present technology will be described with reference to Fig. 9. Fig. 9 is a cross-sectional view showing the configuration example of the thermoelectric conversion element 30.

The thermoelectric conversion element 30 differs from the thermoelectric conversion element 10 according to the first embodiment in that the absorption layer is disposed between the substrate and the thermoelectric conversion layer and the hot point electrode and the cold point electrode are disposed to be vertically inverted. Other configurations of the thermoelectric conversion element 30 are the same as those of the thermoelectric conversion element 10.

As shown in Fig. 9, the thermoelectric conversion element 30 includes, for example, a substrate 31, a thin film thermoelectric conversion layer 32 that is stacked on the front surface of the substrate 31, a hot point electrode 33 that is a first electrode on a high temperature side which is disposed on a lower surface of the thermoelectric conversion layer 32, a cold point electrode 35 that is a second electrode on a low temperature side which is disposed on an upper surface of the thermoelectric conversion layer 12, and an absorption layer 38 that is stacked in contact with the lower surface of the thermoelectric conversion layer 32 between the substrate 11 and the thermoelectric conversion layer 32 and absorbs heat received from the outside.

Further, a hot point electrode wiring 34 is connected to the hot point electrode 33, and a cold point electrode wiring 36 is connected to the cold point electrode 35. An electrometer 37 for reading a potential between the two electrodes of the hot point electrode 33 and the cold point electrode 35 is provided between the hot point electrode wiring 34 and the cold point electrode wiring 36.

Fig. 9 is a schematic view of a vertically inverted structure (a conceptual view of a configuration in which infrared light is applied from the back surface side of the substrate and the hot point is on the substrate side), and a thin film stacked thermoelectric conversion element that can make a temperature difference in a direction that is not horizontal to the substrate is defined as a higher concept of the present embodiment. In the case of applying infrared light from the substrate 31, a configuration as shown in Fig. 9 can be used.

According to the thermoelectric conversion element 30 of the present embodiment, similarly to the thermoelectric conversion element 10 according to the first embodiment, it is possible to provide a thermoelectric conversion element that enables high sensitivity and high speed response while reducing the size of the element.

### 3. Third embodiment

Next, a configuration example of a thermoelectric conversion element 40 according to a third embodiment of the present technology will be described with reference to Fig. 10. Fig. 10 is a cross-sectional view showing the configuration example of the thermoelectric conversion element 40.

The thermoelectric conversion element 40 differs from the thermoelectric conversion element 30 according to the second embodiment in that a slit structure is provided in the substrate. Other configurations of the thermoelectric conversion element 40 are the same as those of the thermoelectric conversion element 30.

As shown in Fig. 10, the thermoelectric conversion element 40 includes, for example, a substrate 41, a thin film thermoelectric conversion layer 42 that is stacked on the front surface of the substrate 41, a hot point electrode 43 that is a first electrode on a high temperature side which is disposed on a lower surface of the thermoelectric conversion layer 42, a cold point electrode 45 that is a second electrode on a low temperature side which is disposed on an upper surface of the thermoelectric conversion layer 42, and an absorption layer 48 that is stacked in contact with the lower surface of the thermoelectric conversion layer 42 between the substrate 41 and the thermoelectric conversion layer 42 and absorbs heat received from the outside.

Further, a hot point electrode wiring 44 is connected to the hot point electrode 43, and a cold point electrode wiring 46 is connected to the cold point electrode 45. An electrometer 47 for reading a potential between the two electrodes of the hot point electrode 43 and the cold point electrode 45 is provided between the hot point electrode wiring 44 and the cold point electrode wiring 46.

In the thermoelectric conversion element 40, a slit structure is provided at a lower position from the thermoelectric conversion layer 42 and the absorption layer 48 near the center of the substrate 41 in order to apply the present technology even in a case where it is difficult to provide an infrared-transmitting material as the substrate 41.

According to the thermoelectric conversion element 40 of the present embodiment, similarly to the thermoelectric conversion element 10 according to the first embodiment, it is possible to provide a thermoelectric conversion element that enables high sensitivity and high speed response while reducing the size of the element.

### 4. Fourth embodiment

### (Overview)

Incidentally, the thermoelectromotive force ΔV generated in the thermoelectric conversion layer can be represented by ΔV = S·ΔT (S: Seebeck coefficient, ΔT: temperature gradient). Therefore, ΔV can be increased as S and ΔT are increased. Here, in order to increase ΔT, it is necessary to lower the thermal conductivity of the thermoelectric conversion layer in a direction in which ΔT occurs (for example, the stacking direction).

Fig. 11A is a view for explaining a thermal conductivity of an example in which graphite is used for the thermoelectric conversion layer. The graphite has thermal conduction anisotropy in which the thermal conductivity in a direction perpendicular to a plane (a c-axis direction) is lower than the thermal conductivity in a plane direction (an ab plane direction) (see Fig. 14). Therefore, for example, as shown in Fig. 11A, by causing IR light to be incident on the graphite in the c-axis direction, it is possible to transmit heat in the c-axis direction with a lower thermal conductivity. Therefore, in the thermoelectric conversion element, by adopting a configuration in which a hot point electrode is disposed on one side (the incidence side) of the graphite in the c-axis direction and a cold point electrode is disposed on the other side thereof (a configuration having a temperature gradient ΔT in the c-axis direction), it is possible to increase ΔT, that is, to increase ΔV.

Fig. 11B is a view for explaining a thermal conductivity of an example in which a graphite interlayer compound is used for the thermoelectric conversion layer. The graphite interlayer compound has thermal conduction anisotropy in which the thermal conductivity in a direction perpendicular to a plane (a c-axis direction) is much lower than the thermal conductivity in a plane direction (an ab plane direction) (see Fig. 14). In the graphite interlayer compound, a guest material, which is a different material, is disposed between the graphite layers (host layers) of the graphite having thermal conduction anisotropy as described above. Therefore, phonon scattering occurs during heat conduction, and the thermal resistance increases, and thus the thermal conductivity particularly in the c-axis direction is remarkably lowered. That is, in the graphite interlayer compound, thermal conduction anisotropy in which the thermal conductivity in the c-axis direction is lower than the thermal conductivity in the ab plane direction is much larger than that of the graphite. Therefore, for example, as shown in Fig. 11B, by causing IR light to be incident on the graphite interlayer compound in the c-axis direction, it is possible to transmit heat in the c-axis direction with a much lower thermal conductivity. Therefore, in the thermoelectric conversion element, by adopting a configuration in which a hot point electrode is disposed on one side (the incidence side) of the graphite interlayer compound in the c-axis direction and a cold point electrode is disposed on the other side thereof (a configuration having a temperature gradient ΔT in the c-axis direction), it is possible to extremely increase ΔT, that is, to extremely increase ΔV.

Fig. 12 is a comparison diagram of the thermal conductivities of the graphite and the graphite interlayer compound (Stages 1 to 4). The graphite interlayer compounds of Stages 1 to 4 are the graphite interlayer compounds used in Configuration Examples 1 to 4 of the thermoelectric conversion element according to the present technology. In the graphite interlayer compound of Stage 1, the guest material (for example, MoCl₅) is disposed between all the graphite layers. In the graphite interlayer compound of Stage 2, the guest material is disposed every other between the graphite layers. In the graphite interlayer compound of Stage 3, the guest material is disposed every other two between the graphite layers. In the graphite interlayer compound of Stage 4, the guest material is disposed every other three between the graphite layers.

As shown in Fig. 12, it can be seen that, while the thermal conductivity κ of the graphite in the c-axis direction is about 5 Wm⁻¹K⁻¹, the thermal conductivity κ of the graphite interlayer compound using, for example, MoCl₅ as a guest material in the c-axis direction is about 0.3m⁻¹K⁻¹, which is 0.06 times the thermal conductivity κ of the graphite and is extremely low. Furthermore, it can be seen that, among the graphite interlayer compounds, the higher the density of the guest material disposed in the c-axis direction, the greater the effect of the increase in thermal resistance due to phonon scattering, and the lower the thermal conductivity in the c-axis direction (see Fig. 14). As can be seen from Fig. 14, the thermal conductivity in the c-axis direction decreases in the order of the graphite, Stage 4, Stage 3, Stage 2, and Stage 1.

Fig. 13 is a view for explaining thermal conduction anisotropy of a thermoelectric conversion layer of a thermoelectric conversion element according to Configuration Example 1 (a thermoelectric conversion element having a thermoelectric conversion layer of a graphite interlayer compound of Stage 1 having a temperature gradient ΔT in the c-axis direction) of the present technology. In the thermoelectric conversion layer of Configuration Example 1 of the present technology, a first thermal conductivity, which is a thermal conductivity in the direction perpendicular to the plane (the c-axis direction), is preferably 0.2 Wm⁻¹K⁻¹ or more and 0.4 Wm⁻¹K⁻¹ or less, for example, and a second thermal conductivity, which is a thermal conductivity in the plane direction, is preferably 100 Wm⁻¹K⁻¹ or more and 400 Wm⁻¹K⁻¹ or less, for example. In addition, the ratio of the second thermal conductivity to the first thermal conductivity is preferably 100 or more and 1100 or less, for example, more preferably 170 or more and 1000 or less, for example, and even more preferably 600 or more and 1000 or less, for example (see Fig. 14).

Fig. 14 is a table showing a thermal conductivity and a Seebeck coefficient in a plane direction and a thermal conductivity and a Seebeck coefficient in a direction perpendicular to a plane of each of the graphite and the graphite interlayer compound (Stages 1 to 4). As shown in Fig. 14, the first thermal conductivity (the thermal conductivity in the c-axis direction) is 0.23 Wm⁻¹K⁻¹ for Stage 1, 0.3 Wm⁻¹K⁻¹ for Stage 2, 0.35 Wm⁻¹K⁻¹ for Stage 3, and 0.39 Wm⁻¹K⁻¹ for Stage 4, which are all within the preferred range. Further, the ratio of the second thermal conductivity (the thermal conductivity in the ab plane direction) to the first thermal conductivity (the thermal conductivity in the c-axis direction) is 652 for Stage 1, 666 for Stage 2, 1000 for Stage 3, and 897 for Stage 4, which are all within the above preferred range.

As can be seen from Fig. 14, the Seebeck coefficient in the c-axis direction increases in the order of the graphite, Stage 4, Stage 3, Stage 2, and Stage 1. The graphite interlayer compound of each stage also has a large advantage over the graphite in terms of the Seebeck coefficient. Furthermore, the Seebeck coefficient in the c-axis direction increases and the thermal conductivity in the c-axis direction decreases (ΔT increases) in the order of Stage 4, Stage 3, Stage 2, and Stage 1. Therefore, ΔV increases in the order of Stage 4, Stage 3, Stage 2, and Stage 1.

Fig. 15 is a graph showing sensitivity and responsiveness of the graphite (two layouts) and the graphite interlayer compound (two layouts of Stage 1) as the thermoelectric conversion layer. In Fig. 15, each layout has the same thickness (a thickness in a direction in which the temperature gradient occurs) (for example, 60 pm).

From Fig. 15, it can be seen that the graphite interlayer compound of Stage 1, which has a temperature gradient ΔT in the c-axis direction, can realize a more localized thermal gradient in the c-axis direction and exhibits high sensitivity and high speed response (a rectangular pulse in Fig. 15). In particular, it can be seen that MoCl₅-GIC easily generates a local thermal gradient between fine thin film regions of several pm to several tens of µm. On the other hand, from Fig. 15, it can be seen that the sensitivity and the responsiveness of each of the graphite interlayer compound of Stage 1 having a temperature gradient ΔT in the ab plane direction, the graphite having a temperature gradient ΔT in the c-axis direction, and the graphite having a temperature gradient ΔT in the ab-plane direction are remarkably low.

### (Thermoelectric conversion element of Configuration Example 1)

### <<Structure of thermoelectric conversion element>>

Fig. 16 is a cross-sectional view of a thermoelectric conversion element 50 according to Configuration Example 1 of a fourth embodiment of the present technology. Fig. 17 is a plan view of the thermoelectric conversion element 50 according to Configuration Example 1 of the fourth embodiment of the present technology. Fig. 16 is a cross-sectional view along line P-P of Fig. 17.

As an example, as shown in Fig. 16, the thermoelectric conversion element 50 includes, for example, a substrate 51a, a thin film thermoelectric conversion layer 52 that is stacked on the substrate 51a, a hot point electrode 53 (a lower electrode) that is a first electrode on a high temperature side which is disposed on a lower surface of the thermoelectric conversion layer 52, a cold point electrode 55 (an upper electrode) that is a second electrode on a low temperature side which is disposed on an upper surface of the thermoelectric conversion layer 52, and an absorption layer 51c1 that is disposed on a lower surface side of the thermoelectric conversion layer 52 and absorbs heat received from the outside. The thermoelectric conversion element 50 can be equipped with an electrometer for reading a potential between the two electrodes of the hot point electrode 53 and the cold point electrode 55.

As an example, the hot point electrode 53 is at least partially sandwiched between the thermoelectric conversion layer 52 and the absorption layer 51c1. The hot point electrode 53 is, for example, an electrode pad having a stacked structure (for example, a two-layer structure of Pt/Cr). The size of the electrode pad is, for example, 10 pm × 10 pm, and the thickness of the Pt layer is, for example, 100 nm, and the thickness of the Cr layer is, for example, 10 nm.

As an example, the hot point electrode 53 is connected to a connecting portion that connects U-shaped opposing sides of a hot point electrode wiring 54, which is substantially U-shaped in a plan view (see Fig. 17).

The cold point electrode 55 is connected to an electrode pad 59 via a bonding wire as a cold point electrode wiring 56.

For example, by connecting the electrometer between the electrode pad 59 and the hot point electrode wiring 54, the thermoelectromotive force ΔV generated in the thermoelectric conversion layer 52 can be measured.

As an example, the substrate 51a and a substrate 51c having the absorption layer 51c1 in a part (for example, a central portion) in the plane direction constitute an SOI (Silicon on Insulator) substrate 51 together with an insulating layer 51b. The substrate 51a is a Si substrate that is a lower layer of the SOI substrate 51. The substrate 51c is a Si substrate that is an upper layer of the SOI substrate 51. The insulating layer 51b is an intermediate layer (for example, a SiO₂ film) of the SOI substrate 51. The thickness of the substrate 51a is, for example, 300 pm. The thickness of the substrate 51c is, for example, 3 pm. The thickness of the insulating layer 51b is, for example, 270 nm. The substrate 51c has a size of 12 pm × 12 pm, for example.

A hole 51H for taking in the IR light is provided in the back surface (the lower surface) of the SOI substrate 51. The hole 51H penetrates the substrate 51a and the insulating layer 51b and exposes the absorption layer 51c1. That is, the bottom surface of the hole 51H is a part (for example, a central portion) of the lower surface of the absorption layer 51c1.

Alight reflection layer 57 is provided on the entire surface of the SOI substrate 51 except for the hole 51H on the back surface thereof. The light reflection layer 57 has, for example, a stacked structure (for example, a two-layer structure of Au/Cr (Au film thickness: 100 nm, Cr film thickness: 10 nm)). The light reflection layer 57 may have a single layer structure.

Part of the IR light applied from the back surface side of the SOI substrate 51 is incident on the absorption layer 51c1 via the hole 51H, and the other part of the IR light is reflected by the light reflection layer 57.

The thermoelectric conversion layer 52 is made of an interlayer compound. More specifically, the thermoelectric conversion layer 52 is made of, for example, the graphite interlayer compound (GIC) of Stage 1 having a temperature gradient ΔT in the c-axis direction.

As an example, the thermoelectric conversion layer 52 is disposed such that the c-axis direction (the stacking direction) substantially coincides with an alignment direction (a vertical direction) of the hot point electrodes 53 and the cold point electrodes 55.

As the thermoelectric conversion layer 52, the interlayer compound has a layered material made of a plurality of stacked host layers 52a and a guest material 52b (intercalated) disposed between the host layers 52a.

The total thickness of the thermoelectric conversion layer 52 is, for example, about 50 to 1000 nm. The pitch of the guest materials 52b in the c-axis direction (the stacking direction) is, for example, about 0.9 nm.

Examples of the host material that is the material of the plurality of host layers 52a include layered materials such as graphite and various transition metal chalcogenides.

Examples of the host material include layered compounds formed of any one element of C, Si, Ge, Sb and P.

Further, examples of the host material include layered compounds represented by a compositional formula MX₂. M is any one of Ti, Zr, Hf, V, Nb, Ta, Mo, W, Sc, Mn, Fe, Ni, Cr, Pd, Pt, Re, Ga, Ge, Sn, Pb, and In, and X is any one of O, S, Se, and Te.

Further, examples of the host material include layered compounds represented by a compositional formula of MX. M is Ga or In, and X is any one of O, S, Se, and Te. Further, examples of the material of a conductor atomic layer thin film include layered compounds represented by a compositional formula of M₂X₃. M is Bi, and X is any one of O, S, Se, and Te.

Examples of the host material include layered compounds represented by a compositional formula L_{X}M_{1-X}A_{Y}B_{1-Y} (0 ≤ X ≤ 1), (0 ≤ Y ≤ 1). L is any one of Ti, Zr, Hf, V, Nb, Ta, Mo, W, Sc, Mn, Fe, Ni, Cr, Pd, Pt, Re, Ga, Ge, Sn, Pb, and In, and M is any one of Ti, Zr, Hf, V, Nb, Ta, Mo, W, Sc, Mn, Fe, Ni, Cr, Pd, Pt, Re, Ga, Ge, Sn, Pb, and In. A is any one of N, O, P, S, Se, and Te, and B is any one of N, O, P, S, Se, and Te.

Examples of the guest material 52b include metals, metal compounds (metal oxide, metal nitride, metal chloride, and metal oxyhalide), various organic molecules, carbides, and the like.

The thermoelectric conversion layer 52 has thermal conduction anisotropy. More specifically, in the thermoelectric conversion layer 52, the first thermal conductivity that is a thermal conductivity in the stacking direction (the c-axis direction) is lower than the second thermal conductivity that is a thermal conductivity in the plane direction (the ab plane direction) (see Fig. 14).

The ratio of the second thermal conductivity to the first thermal conductivity is preferably 100 or more, more preferably 170 or more, even more preferably 600 or more, and further more preferably 650 or more (see Fig. 14). The ratio of the second thermal conductivity to the first thermal conductivity is preferably 1100 or less, more preferably 1000 or less, for example, and even more preferably 900 or less.

In consideration of a thin film manufacturing process of the thermoelectric conversion layer 52, the film thickness of the thermoelectric conversion layer 52 is preferably 100 pm or less, and thus the first thermal conductivity is preferably 0.05 W/(m K) or more and 10 W/(m K) or less and more preferably 0.10 W/(m .K) or more and 5.0 W/(m K) or less. The lower the thermal conductivity, the larger the local thermal gradient, but in consideration of the response speed, thermal conductivity is preferably 0.10 W/(m .K) or more.

Furthermore, the first thermal conductivity is preferably 0.45 W/(m .K) or less (see Fig. 14). Furthermore, the first thermal conductivity is preferably 0.2 W/(m .K) or more and 0.4 W/(m .K) or less and more preferably 0.22 W/(m .K) or more and 0.395 W/(m .K) or less (see Fig. 14).

The first and second thermal conductivities can be measured, for example, by a thermo-reflectance method. This method enables unsteady measurement of object temperature with high time resolution by measuring the reflection intensity of the applied laser light. For example, the thermal conductivity of the thermoelectric conversion layer can be measured by applying laser light from the upper electrode side.

Here, it is possible to adjust κ in the c-axis direction by combining the host material that is the material of the host layer 52a and the guest material 52b (the material to be intercalated) or by changing the stage between Stages 1 to 4. More specifically, in MoCl₅-GIC, it is possible to reduce the thermal conductivity in the c-axis direction by lowering the stage (decreasing the stage number) (see Fig. 14). Further, it is also possible to control the κ anisotropy (the thermal conduction anisotropy) by subjecting the host material to heat treatment or acid treatment in advance.

### <<Operation of thermoelectric conversion element>>

Next, an operation of the thermoelectric conversion element 50 will be described. In the present embodiment, a case in which the infrared light IR is incident on the absorption layer 51c1 of the thermoelectric conversion element 50 is considered.

When the absorption layer 51c1 is irradiated with the infrared light IR and the absorption layer 51c1 absorbs heat due to the infrared light IR, heat associated with the absorption of the infrared light IR is generated between the hot point electrode 53 and the cold point electrode 55, and thus a temperature difference occurs. For this reason, a thermoelectromotive force ΔV is generated in the thermoelectric conversion layer 52 due to diffusion of thermal carriers. At this time, since the thermoelectric conversion layer 52 has a low thermal conductivity and a large Seebeck coefficient in the c-axis direction, a large thermoelectromotive force ΔV can be generated.

### <<Method of manufacturing thermoelectric conversion element>>

A method of manufacturing the thermoelectric conversion element 50 will be described below with reference to a flowchart of Fig. 18 and cross-sectional views of Figs. 19A to 22B.

In a first step S1, a lower structure including the lower electrode (the hot point electrode 53) is formed. Specifically, first, the SOI substrate 51 is prepared (see Fig. 19A). Next, the back surface (the lower surface) of the SOI substrate 51 is etched by dry etching to form the holes 51H (see Fig. 19B). Next, the light reflection layer 57 is formed on the entire surface of the SOI substrate 51 except for the hole 51H (see Fig. 19C). Next, the substrate 51c is etched by dry etching to form the absorption layer 51c1 (see Fig. 20A). Next, the hot point electrode 53 and the hot point electrode wiring 54 are patterned on the substrate 51c on which the absorption layer 51c1 is formed by photolithography (see Fig. 20B).

In the next step S2, the graphite to be the plurality of host layers 52a is transferred (see Fig. 20C). Specifically, the Kish graphite or a highly oriented pyrolytic graphite (Alliance Biosystems, Inc., Tomoe Engineering Co., Ltd., or the like) is transferred onto the hot point electrode 53. This transfer is performed, for example, by holding the graphite with a manipulator having a diameter of 50 pm and pressing the graphite against the hot point electrode 53 with a constant pressure in a nitrogen gas atmosphere such that the graphite has a film thickness of, for example, 20 pm.

In the next step S3, the upper electrode (the cold point electrode 55) is formed (see Fig. 21A). Specifically, the electrode pad, which is the cold point electrode 55, is formed on the graphite by photolithography.

In the next step S4, the graphite is etched (see Fig. 21B). Specifically, the thermoelectric conversion layer 52 is formed by etching the graphite by dry etching.

In the next step S5, the guest material 52b is inserted (intercalated) between the host layers 52a (see Fig. 22A). Specifically, the guest material (for example, MoCl₅) is inserted between the host layers 52a of the graphite (the graphite layers) which are the host materials by a vapor phase method. Specifically, high-temperature heating is performed in a vacuum environment of 5 Pa or less. The heating time at this time is from 1 hour to 100 hours, and the heating temperature is from 200 to 500 °C. As a result, the thermoelectric conversion layer 52 having a total film thickness of 60 pm, for example, is produced.

In the final step S6, the upper electrode (the cold point electrode 55) is joined to the electrode pad. Specifically, the cold point electrode 55 is connected to the electrode pad 59 by wire bonding (via the cold point electrode wiring 56).

The thermoelectric conversion elements of Configuration Examples 2 and 3, which each have the graphite interlayer compound of Stages 2 to 4 each having a temperature gradient ΔT in the c-axis direction, have the same configuration as the thermoelectric conversion element 50 of Configuration Example 1 described above except that the stage of the graphite interlayer compound different and can be manufactured by the same manufacturing method.

Further, any of the graphite interlayer compounds of Stages 1 to 4 having a temperature gradient ΔT in the c-axis direction may be used as the thermoelectric conversion layer of each of the thermoelectric conversion elements of the first to third embodiments.

Further, the graphite may be used as the material having the thermal conduction anisotropy in the thermoelectric conversion layer of each of the thermoelectric conversion elements of the first to fourth embodiments. In this case, it is preferable to use the graphite having a temperature gradient ΔT in the c-axis direction.

The present technology can have the following configuration.
(1)
   A thermal type detection element comprising:
   a substrate;
   a thin film thermoelectric conversion layer that is stacked on the substrate;
   a first electrode on a high temperature side that is disposed on one surface of the thermoelectric conversion layer;
   a second electrode on a low temperature side that is disposed on the other surface of the thermoelectric conversion layer; and
   an absorption layer that is disposed on one surface side of the thermoelectric conversion layer and absorbs heat received from the outside.
(2) The thermal type detection element according to (1),
   wherein the one surface is an upper surface of the thermoelectric conversion layer, and the other surface is a lower surface of the thermoelectric conversion layer,
   wherein the first electrode is disposed at a contact surface between a lower surface of the absorption layer and the upper surface of the thermoelectric conversion layer, and
   wherein the second electrode is disposed at a contact surface between the lower surface of the thermoelectric conversion layer and a front surface of the substrate.
(3) The thermal type detection element according to (1),
   wherein the one surface is a lower surface of the thermoelectric conversion layer, and the other surface is an upper surface of the thermoelectric conversion layer, wherein the first electrode is disposed at a contact surface between the lower surface of the thermoelectric conversion layer and an upper surface of the absorption layer, and
   wherein the second electrode is disposed on the upper surface of the thermoelectric conversion layer.
(4) The thermal type detection element according to (1),
   wherein the one surface is a lower surface of the thermoelectric conversion layer, and the other surface is an upper surface of the thermoelectric conversion layer, wherein the first electrode is sandwiched between the thermoelectric conversion layer and the absorption layer, and
   wherein the second electrode is disposed on the upper surface of the thermoelectric conversion layer.
(5) The thermal type detection element according to any one of (1) to (4), wherein the thermoelectric conversion layer has a thickness thermal resistance per unit cross-sectional area of 1.0 × 10⁻⁶ m²K/W or more and 1.0 × 10⁻³ m²K/W or less.
(6) The thermal type detection element according to any one of (1) to (3), wherein the thermoelectric conversion layer has a thickness thermal resistance per unit cross-sectional area of 1.0 × 10⁻⁵ m²K/W or more and 1.0 × 10⁻⁴ m²K/W or less.
(7) The thermal type detection element according to any one of (1) to (5), wherein the thermoelectric conversion layer is formed of a layered substance in which thin films are stacked.
(8) The thermal type detection element according to (6), wherein the layered substance is a substance selected from graphite, a metal compound containing graphite as a host material, a compound containing an organic molecule or the like inserted as a guest material, a transition metal chalcogenide, and a combination thereof.
(9) The thermal type detection element according to any one of (1) to (7), wherein the thermoelectric conversion layer has an inorganic superlattice structure or an organic superlattice structure.
(10) The thermal type detection element according to any one of (1) to (8), wherein the thermoelectric conversion layer is formed of a compound consisting of elements having a large mass difference or a cage-structured molecule.
(11) The thermal type detection element according to any one of (1) to (9), wherein the thermal type detection element is a thermoelectric conversion element that generates a thermoelectromotive force corresponding to an amount of heat absorbed from the outside.
(12) The thermal type detection element according to (10), wherein the thermoelectric conversion layer has a Seebeck coefficient of 100 pV/K or more.
(13) The thermal type detection element according to (10) or (11), further comprising an electrometer that reads the thermoelectromotive force generated between the first electrode and the second electrode.
(14) The thermal type detection element according to any one of (10) to (12),
   wherein the absorption layer absorbs heat from incident light, and
   wherein the thermal type detection element is a light detection element for an infrared ray.
(15) The thermal type detection element according to any one of (1) to (14), wherein the thermoelectric conversion layer has thermal conduction anisotropy.
(16) The thermal type detection element according to (15), wherein, in the thermoelectric conversion layer, a first thermal conductivity that is a thermal conductivity in a stacking direction is lower than a second thermal conductivity that is a thermal conductivity in a plane direction.
(17) The thermal type detection element according to (15) or (16), wherein a ratio of the second thermal conductivity to the first thermal conductivity is 100 or more and 1100 or less.
(18) The thermal type detection element according to any one of (15) to (17), wherein a ratio of the second thermal conductivity to the first thermal conductivity is 170 or more and 1000 or less.
(19) The thermal type detection element according to any one of (15) to (18), wherein a ratio of the second thermal conductivity to the first thermal conductivity is 600 or more.
(20) The thermal type detection element according to any one of (15) to (19), wherein the first thermal conductivity is 0.45 W/(m K) or less.
(21) The thermal type detection element according to any one of (15) to (20), wherein the first thermal conductivity is 0.2 W/(m .K) or more and 0.4 W/(m K) or less.
(22) The thermal type detection element according to any one of (1) to (21), wherein the thermoelectric conversion layer is made of an interlayer compound.
(23) The thermal type detection element according to (22),
   wherein the interlayer compound has
   a plurality of stacked host layers, and
   a guest material that is disposed between the host layers.
(24) The thermal type detection element according to (23), wherein the plurality of host layers consist of graphite or a transition metal chalcogenide.
(25) The thermal type detection element according to (23) or (24), wherein the guest material includes any one of a metal, a metal compound, an organic molecule, and a carbide.
(26) An image sensor comprising:
   a plurality of the thermal type detection elements according to any one of (1) to (25),
   wherein the plurality of thermal type detection elements are arrayed.

### [Reference Signs List]

10, 30, 40, 50 Thermoelectric conversion element
11, 31, 41, 51a Substrate
12, 32, 42, 52 Thermoelectric conversion layer
13, 33, 43, 53 Hot point electrode (first electrode)
14, 34, 44, 54 Hot point electrode wiring
15, 35, 45, 55 Cold point electrode (second electrode)
16 Address line
17, 36, 46, 56 Cold point electrode wiring
18, 38, 48, 51c1 Absorption layer
19 Insulating film
20 Thermoelectric conversion element unit
21 Thin film
37, 47 Electrometer
IR Infrared ray

## Claims

1. A thermal type detection element comprising:
a substrate;
a thin film thermoelectric conversion layer that is stacked on the substrate;
a first electrode on a high temperature side that is disposed on one surface of the thermoelectric conversion layer;
a second electrode on a low temperature side that is disposed on the other surface of the thermoelectric conversion layer; and
an absorption layer that is disposed on one surface side of the thermoelectric conversion layer and absorbs heat received from the outside.

2. The thermal type detection element according to claim 1,
wherein the one surface is an upper surface of the thermoelectric conversion layer, and the other surface is a lower surface of the thermoelectric conversion layer,
wherein the first electrode is disposed at a contact surface between a lower surface of the absorption layer and the upper surface of the thermoelectric conversion layer, and
wherein the second electrode is disposed at a contact surface between the lower surface of the thermoelectric conversion layer and a front surface of the substrate.

3. The thermal type detection element according to claim 1,
wherein the one surface is a lower surface of the thermoelectric conversion layer, and the other surface is an upper surface of the thermoelectric conversion layer,
wherein the first electrode is disposed at a contact surface between the lower surface of the thermoelectric conversion layer and an upper surface of the absorption layer, and
wherein the second electrode is disposed on the upper surface of the thermoelectric conversion layer.

4. The thermal type detection element according to claim 1,
wherein the one surface is a lower surface of the thermoelectric conversion layer, and the other surface is an upper surface of the thermoelectric conversion layer,
wherein the first electrode is sandwiched between the thermoelectric conversion layer and the absorption layer, and
wherein the second electrode is disposed on the upper surface of the thermoelectric conversion layer.

5. The thermal type detection element according to claim 1, wherein the thermoelectric conversion layer has a thickness thermal resistance per unit cross-sectional area of 1.0 × 10⁻⁶ m²K/W or more and 1.0 × 10⁻³ m²K/W or less.

6. The thermal type detection element according to claim 1, wherein the thermoelectric conversion layer has a thickness thermal resistance per unit cross-sectional area of 1.0 × 10⁻⁵ m²K/W or more and 1.0 × 10⁻⁴ m²K/W or less.

7. The thermal type detection element according to claim 1, wherein the thermoelectric conversion layer is formed of a layered substance in which thin films are stacked.

8. The thermal type detection element according to claim 7, wherein the layered substance is a substance selected from graphite, a metal compound containing graphite as a host material, a compound containing an organic molecule or the like inserted as a guest material, a transition metal chalcogenide, and a combination thereof.

9. The thermal type detection element according to claim 1, wherein the thermoelectric conversion layer has an inorganic superlattice structure or an organic superlattice structure.

10. The thermal type detection element according to claim 1, wherein the thermoelectric conversion layer is formed of a compound consisting of elements having a large mass difference or a cage-structured molecule.

11. The thermal type detection element according to claim 1, wherein the thermal type detection element is a thermoelectric conversion element that generates a thermoelectromotive force corresponding to an amount of heat absorbed from the outside.

12. The thermal type detection element according to claim 11, wherein the thermoelectric conversion layer has a Seebeck coefficient of 100 pV/K or more.

13. The thermal type detection element according to claim 11, further comprising an electrometer that reads the thermoelectromotive force generated between the first electrode and the second electrode.

14. The thermal type detection element according to claim 11,
wherein the absorption layer absorbs heat from incident light, and
wherein the thermal type detection element is a light detection element for an infrared ray.

15. The thermal type detection element according to claim 1, wherein the thermoelectric conversion layer has thermal conduction anisotropy.

16. The thermal type detection element according to claim 15, wherein, in the thermoelectric conversion layer, a first thermal conductivity that is a thermal conductivity in a stacking direction is lower than a second thermal conductivity that is a thermal conductivity in a plane direction.

17. The thermal type detection element according to claim 15, wherein a ratio of the second thermal conductivity to the first thermal conductivity is 100 or more and 1100 or less.

18. The thermal type detection element according to claim 15, wherein a ratio of the second thermal conductivity to the first thermal conductivity is 170 or more and 1000 or less.

19. The thermal type detection element according to claim 15, wherein a ratio of the second thermal conductivity to the first thermal conductivity is 600 or more.

20. The thermal type detection element according to claim 15, wherein the first thermal conductivity is 0.45 W/(m K) or less.

21. The thermal type detection element according to claim 15, wherein the first thermal conductivity is 0.2 W/(m .K) or more and 0.4 W/(m .K) or less.

22. The thermal type detection element according to claim 15, wherein the thermoelectric conversion layer is made of an interlayer compound.

23. The thermal type detection element according to claim 22,
wherein the interlayer compound has
a plurality of stacked host layers, and
a guest material that is disposed between the host layers.

24. The thermal type detection element according to claim 23, wherein the plurality of host layers consist of graphite or a transition metal chalcogenide.

25. The thermal type detection element according to claim 23, wherein the guest material includes any one of a metal, a metal compound, an organic molecule, and a carbide.

26. An image sensor comprising:
a plurality of the thermal type detection elements according to claim 1,
wherein the plurality of thermal type detection elements are arrayed.
